# EUROPÄISCHE PATENTSCHRIFT

(11) **EP 2 862 280 B1**
(45) Veröffentlichungstag und Bekanntmachung des Hinweises auf die Patenterteilung: **12.08.2026**
(21) Anmeldenummer: 13783472.7
(22) Anmeldetag: 18.06.2013
(51) Int. Cl.: H03L 7/113, H04L 7/033

(54) **SCHALTUNGSANORDNUNG UND VERFAHREN ZUR TAKT- UND/ODER DATENRÜCKGEWINNUNG**
CIRCUIT ARRANGEMENT AND METHOD FOR CLOCK AND/OR DATA RECOVERY
CIRCUITERIE ET PROCÉDÉ DE RÉCUPÉRATION D'HORLOGE ET/OU DE DONNÉES

(30) Priorität: 18.06.2012 DE 102012105292
(43) Veröffentlichungstag der Anmeldung: 22.04.2015
(73) Patentinhaber: EverProX Technologies Munich GmbH, 80687 München (DE)
(72) Erfinder: WERKER, Heinz, 82386 Huglfing (DE)
(74) Vertreter: Hofmann, Andreas
(86) Internationale Anmeldenummer: PCT/DE2013/200021
(87) Internationale Veröffentlichungsnummer: WO 2013/189494

(56) Entgegenhaltungen:
- DE-C1- 10 132 232
- US-A1- 2005 242 890
- US-A1- 2006 006 914

## Beschreibung

### Technisches Gebiet

Die vorliegende Erfindung betrifft grundsätzlich das technische Gebiet der Takt- und/oder Datenrückgewinnung (= CDR = Clock and/or Data Recovery); im Spezielleren betrifft die vorliegende Erfindung eine Schaltungsanordnung sowie ein Verfahren zur Takt- und/oder Datenrückgewinnung (vgl. US 2005/0242890 A1; zur Verwendung einer Zustandsmaschine und eines der Zustandsmaschine nachgeschalteten Strom-Digital-Analog-Wandlers in einer Frequenz-Regelungsschaltung vgl. US 2006/0006914 A1). Die DE 101 32 232 C1 offenbart eine Phasendetektorschaltung für einen Phasenregelkreis, insbesondere eine PLL-Schaltung (Phase Locked Loop) oder eine DLL-Schaltung (Delay Locked Loop).

### Stand der Technik, insbesondere dessen Nachteile und technische Probleme

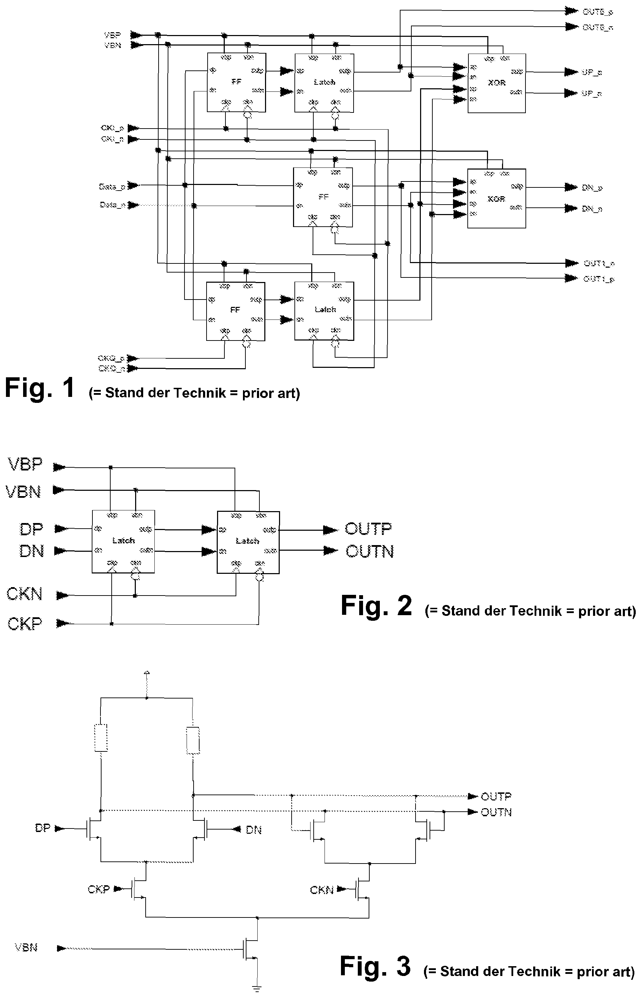

Bei derartigen Schaltungen zur Takt- und/oder Datenrückgewinnung oder CDR-Schaltungen werden hauptsächlich die Art des Phasendetektors und die Art des spannungsgesteuerten Oszillators unterschieden:
- linearer Phasendetektor:
   die lineare Phasendifferenz an beiden Eingängen des Phasendetektors wird am Ausgang des Phasendetektors angezeigt;
- binärer Phasendetektor:
   falls am Dateneingang ein Bitwechsel erfolgt, wird am Ausgang des Phasendetektors das Vorzeichen der Phasendifferenz der beiden Eingänge (Takt und/oder Daten) des Phasendetektors ermittelt (voreilend oder nacheilend); dies kann zum Beispiel durch zwei digitale Phasendetektor-Ausgangssignale "up" (für voreilend) und "down" (für nacheilend) angezeigt werden; für binäre Phasendetektoren wird sehr häufig der im Stand der Technik bekannte Alexander-Phasendetektor eingesetzt (vgl. Fig. 1: mögliche Schaltung zur Implementierung eines Half-Rate-Alexander-Phasendetektors).

CDR-Schaltungen mit Alexander-Phasendetektoren werden häufig bei Datenübertragungen im Frequenzbereich größer als ein Gigahertz eingesetzt, denn sie sind bei begrenzter Geschwindigkeit der verwendeten Technologie einfacher zu implementieren und zeigen ein sehr robustes Verhalten (bessere sogenannte Power-Supply-Rejection).

Für hohe Eingangsdatenraten von mehr als einem Gigahertz werden üblicherweise die notwendigen Logikblöcke des Phasendetektors in C[urrent]M[ode]L[ogic] implementiert. Fig. 2 zeigt die Implementierung eines Flip-Flops in Form zweier Latch-Blöcke, Fig. 3 die Implementierung eines Latch mit resistiver Last (sogenannte R-Load) in C[urrent]M[ode]L[ogic], wobei die Ausgangsimpedanz üblicherweise durch diskrete Poly-Widerstände implementiert wird.

Bei der Implementierung von CDR-Anwendungen, bei denen ein niedriger Ausgangsjitter des erzeugten Ausgangstaktes gefordert ist, wird häufig ein spannungsgesteuerter LC-Oszillator (= VCO = Voltage-Controlled Oscillator) eingesetzt, nicht zuletzt wegen dessen inhärent niedrigen Phasenrauschens. Nachteilig bei dieser konventionellen Schaltungsart sind ein geringer TuningBereich und eine relativ große Chipfläche für die Implementierung der Spule L auf dem Chip.

Bei der Implementierung von CDR-Anwendungen, bei denen ein weiter Tuning-Faktor gefordert ist, wird häufig ein spannungsgesteuerter Ring-Oszillator (= VCO = Voltage-Controlled Oscillator) eingesetzt. Nachteilig bei dieser konventionellen Schaltungsart ist der im Vergleich zum LC-Oszillator höhere Ausgangsjitter aufgrund des höheren Phasenrauschens des Ring-Oszillators. Auch hier wird, wie beim Phasendetektor für Frequenzen von mehr als einem Gigahertz, der Ringoszillator üblicherweise als CML implementiert.

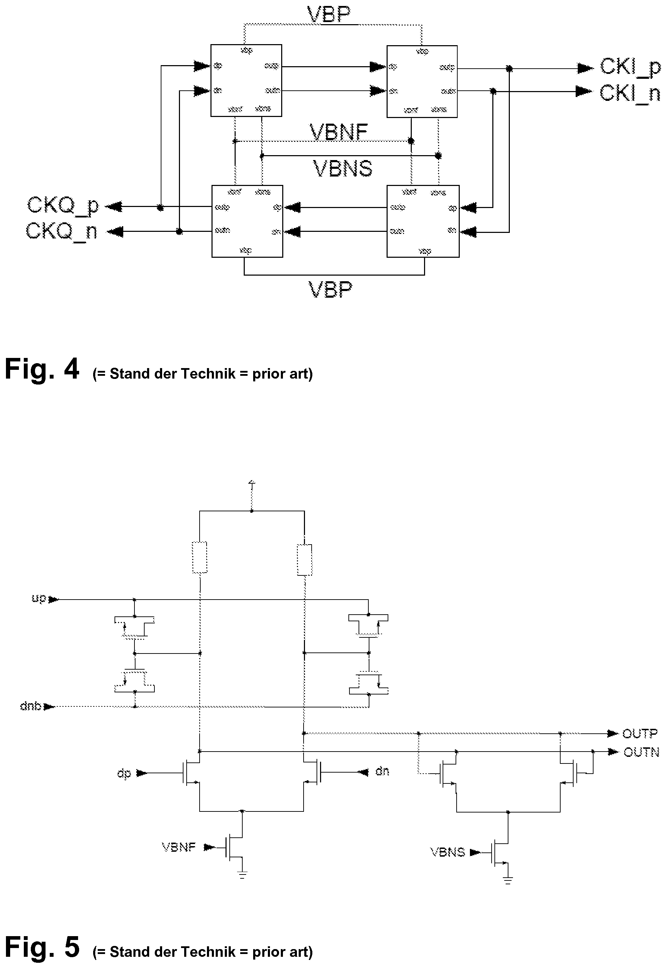

Fig. 4 zeigt einen Ringoszillator, der in Form von vier spannungsgesteuerten Oszillator-Puffer-Stufen VCB implementiert ist und hierbei automatisch zwei Takte CLKI und CLKQ erzeugt, die jeweils eine Phasenverschiebung von neunzig Grad aufweisen. Die Erzeugung von CLKI und CLKQ ist bei der Implementierung eines Half-Rate-Phasendetektors vorteilhaft.

Fig. 5 zeigt eine mögliche Implementierung einer spannungsgesteuerten Oszillator-Puffer-Stufe VCB mit resistiver Ausgangslast (sogenannte R-Load), wobei die Frequenz des Ringoszillators über die Variation der Spannungen an den Pins VBNF und VBNS um einen Faktor von etwa 2,5 verändert werden kann. Für eine höhere Variation der Frequenz des Oszillators (Datenrate), zum Beispiel um den Faktor 5, kann ein Teiler (N = 2) am Ausgang des Oszillators wahlweise zugeschaltet werden.

Die Nachteile der gemäß den Beispielen der Fig. 1 bis Fig. 5 beschriebenen konventionellen Lösungen sind zum einen ein hoher Energieverbrauch wegen der Notwendigkeit einer zusätzlichen Teiler-Schaltung (N = 2) für niedrigere Datenraten; zum anderen kann mittels dieser konventionellen Lösungen nicht die Verlustleistung der Takt- und/oder Datenrückgewinnung (= CDR = Clock and/or Data Recovery) mit der Datenrate skaliert werden.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung sowie ein Verfahren der eingangs genannten Art so weiterzubilden, dass eine Schaltungsanordnung sowie ein entsprechendes Verfahren mit niedrigem Energieverbrauch, mit niedriger Verlustleistung sowie mit Skalierbarkeit der Verlustleistung der Takt- und/oder Datenrückgewinnung mit der Datenrate bereitgestellt werden.

Diese Aufgabe wird durch eine Schaltungsanordnung mit den Merkmalen des Anspruchs 1 sowie durch ein Verfahren mit den Merkmalen des Anspruchs 8 gelöst. Vorteilhafte Ausgestaltungen und zweckmäßige Weiterbildungen der vorliegenden Erfindung sind in den jeweiligen Unteransprüchen gekennzeichnet.

Erfindungsgemäß wird ein CDR-Konzept für einen großen Tuningbereich (mit Faktor von mindestens 5) bei niedriger Verlustleistung bereit gestellt. Hierzu werden die konventionellerweise resistiven Lasten in der C[urrent]M[ode]L[ogic] durch als Lastwiderstände arbeitende Transistoren, insbesondere NMOS-Transistoren, zum Beispiel n-Kanal-Metall-Oxid-Halbleiter-Feldeffekttransistor, ersetzt.

Durch diese Maßnahme kann sowohl der Leitwert der VCO-Puffer-Stufe als auch die Ausgangslast in Abhängigkeit von der Oszillator-Ausgangsfrequenz variiert werden, was zu einem höheren Tuningbereich des spannungsgesteuerten Oszillators, insbesondere des spannungsgesteuerten LC-Oszillators, zum Beispiel des Ringoszillators, führt.

Da auch in der CML des Phasendetektors in allen Logik-Gattern die konventionellerweise resistiven Lasten durch als Lastwiderstände arbeitende Transistoren, insbesondere NMOS-Lasten, ersetzt werden, wird die Verlustleistung der CDR-Schaltung automatisch abhängig von der Datenrate am Eingang der CDR-Schaltung. Dies bedeutet zum Beispiel, dass bei Halbierung der Datenrate am CDR-Eingang die Verlustleistung der CDR-Schaltung um den Faktor 4 reduziert wird.

Grundsätzlich weist die CDR-Schaltung
- mindestens eine Frequenz-Regelungsschaltung und
- mindestens eine Phasen-Regelungsschaltung
auf, wobei zunächst nur die Frequenz-Regelungsschaltung zum Einstellen der Frequenz in Abhängigkeit von der Datenrate, mit der der Dateneingang beaufschlagbar ist, aktiv ist und dann zum Ermitteln der Phasendifferenz zwischen dem Dateneingang und dem Takteingang auf die Phasen-Regelungsschaltung umgeschaltet wird.

Die vorliegende Erfindung betrifft schließlich die Verwendung mindestens einer Schaltungsanordnung gemäß der vorstehend dargelegten Art und/oder eines Verfahrens gemäß der vorstehend dargelegten Art bei der Takt- und/oder Datenrückgewinnung (= CDR = Clock and/or Data Recovery) mit mindestens einem Phasendetektor und mit mindestens einem spannungsgesteuerten Oszillator, insbesondere bei optimierter Verlustleistung bezüglich einer Variation der Eingangs-Datenrate um etwa den Faktor 5.

Die vorliegende Erfindung zeichnet sich also zum einen durch einen niedrigen Strombedarf, das heißt durch einen niedrigen Energieverbrauch aus, denn der Strombedarf ist eine Funktion der Datenrate; vielmehr ist durch die vorliegende Erfindung auch eine niedrige Verlustleistung realisierbar, denn die Schaltung gemäß der vorliegenden Erfindung sowie das Verfahren gemäß der vorliegenden Erfindung können mit sehr niedriger Versorgungsspannung, zum Beispiel im Bereich von weniger als 1,5 Volt, arbeiten.

Auch wird durch die vorliegende Erfindung eine große Variation der Datenrate - etwa um den Faktor 5 - ermöglicht, denn in der verwendeten C[urrent]M[ode]L[ogic] wird zusätzlich zum Leitwert auch die Ausgangslast auf den optimalen Wert eingestellt. Demzufolge ist die Verlustleistung der Takt- und/oder Datenrückgewinnung in besonders zweckdienlicher Weise mit der Datenrate skalierbar.

### Kurze Beschreibung der Zeichnungen

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 8 nachgeordneten Ansprüche verwiesen, andererseits werden weitere Ausgestaltungen, Merkmale und Vorteile der vorliegenden Erfindung nachstehend unter Anderem anhand des durch Fig. 5 bis Fig. 9 veranschaulichten Ausführungsbeispiels näher erläutert. Es zeigt:
- Fig. 1: in konzeptuell-schematischer Darstellung ein Schaltungsbeispiel für einen Half-Rate-Alexander-Phasendetektor aus dem Stand der Technik, der nach dem Verfahren aus dem Stand der Technik arbeitet;
- Fig. 2: in konzeptuell-schematischer Darstellung ein Schaltungsbeispiel für einen Flip-Flop aus dem Stand der Technik, der nach dem Verfahren aus dem Stand der Technik arbeitet;
- Fig. 3: in konzeptuell-schematischer Darstellung ein Schaltungsbeispiel für einen Latch mit resistiver Last in C[urrent]M[ode]L[ogic] aus dem Stand der Technik, der nach dem Verfahren aus dem Stand der Technik arbeitet;
- Fig. 4: in konzeptuell-schematischer Darstellung ein Schaltungsbeispiel für einen Ringoszillator aus dem Stand der Technik, der nach dem Verfahren aus dem Stand der Technik arbeitet;
- Fig. 5: in konzeptuell-schematischer Darstellung ein Schaltungsbeispiel für eine spannungsgesteuerte Oszillator-Puffer-Stufe aus dem Stand der Technik, die nach dem Verfahren aus dem Stand der Technik arbeitet;
- Fig. 6: in konzeptuell-schematischer Darstellung ein Ausführungsbeispiel für eine spannungsgesteuerte Oszillator-Puffer-Stufe gemäß der vorliegenden Erfindung, die Teil der erfindungsgemäßen Schaltungsanordnung aus Fig. 9 ist und nach dem Verfahren gemäß der vorliegenden Erfindung arbeitet;
- Fig. 7: in konzeptuell-schematischer Darstellung ein Ausführungsbeispiel für einen, insbesondere als Flip-Flop-Schaltung, zum Beispiel als zustandsgesteuerte Flip-Flop-Schaltung, ausgebildeten Latch gemäß der vorliegenden Erfindung, der Teil der erfindungsgemäßen Schaltungsanordnung aus Fig. 9 ist und nach dem Verfahren gemäß der vorliegenden Erfindung arbeitet;
- Fig. 8: in diagrammatischer Darstellung die Tuning-Charakteristik des spannungsgesteuerten Oszillators aus Fig. 6, wobei die Ansteuerspannung auf der Rechtsachse aufgetragen ist; und
- Fig. 9: in konzeptuell-schematischer Darstellung ein Ausführungsbeispiel für eine Schaltungsanordnung gemäß der vorliegenden Erfindung, die nach dem Verfahren gemäß der vorliegenden Erfindung arbeitet.

Gleiche oder ähnliche Ausgestaltungen, Elemente oder Merkmale sind in Fig. 1 bis Fig. 9 mit identischen Bezugszeichen versehen, wobei hinsichtlich der Bezeichnung der Signale bzw. der entsprechenden Signaleingänge und -ausgänge nicht zwischen Kleinschreibung und Großschreibung unterschieden wird.

### Bester Weg zur Ausführung der vorliegenden Erfindung

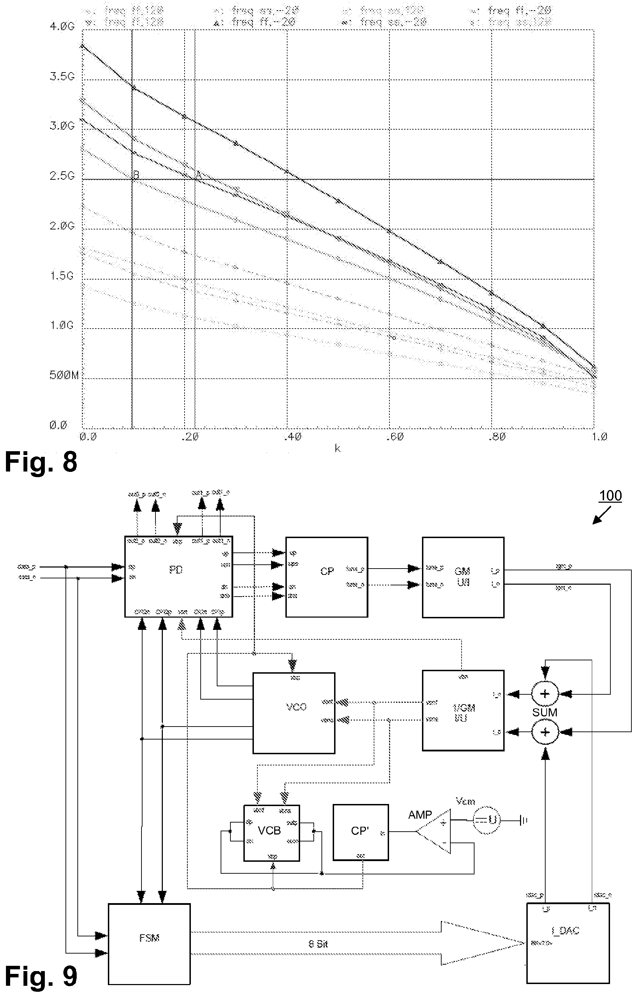

Die mit Dateneingang und Takteingang ausgestattete Schaltungsanordnung 100 zur Takt- und/oder Datenrückgewinnung (= CDR = Clock and/or Data Recovery) gemäß Fig. 9 weist konzeptionell im Wesentlichen mindestens zwei Regelschleifen auf.

Die erste Regelschleife in Form einer Frequenz-Regelungsschaltung weist eine Zustandsmaschine FSM, einen der Zustandsmaschine FSM nachgeschalteten, acht Bitprogrammierbaren Strom-Digital-Analog-Wandler I_DAC, einen dem Strom-Digital-Analog-Wandler I_DAC nachgeschalteten Strom-Spannungs-Umsetzer 1/GM in Form eines Transimpedanzverstärkers und einen dem Strom-Spannungs-Umsetzer 1/GM nachgeschalteten, mit einem Regelspannungssignal VBP beaufschlagbaren spannungsgesteuerten Oszillator VCO auf, der insbesondere als spannungsgesteuerter LC-Oszillator, zum Beispiel als Ringoszillator, ausgebildet sein kann.

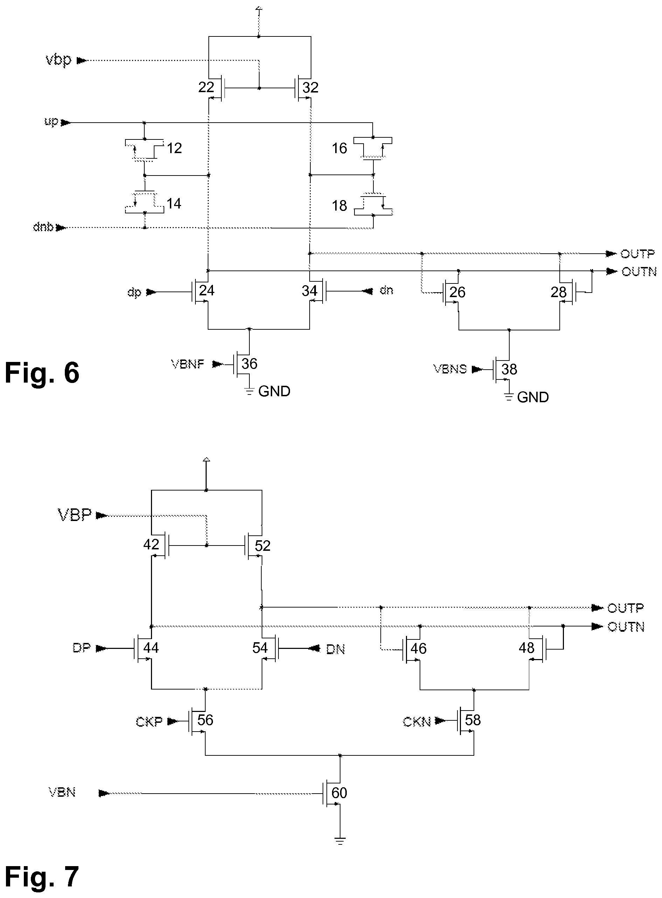

Wie der Detaildarstellung gemäß Fig. 6 entnehmbar, weist der spannungsgesteuerte Oszillator VCO und/oder eine spannungsgesteuerte Oszillator-Puffer-Stufe VCB auf:
- einen ersten Varaktor (12) und einen zweiten Varaktor (14), wobei der kathodische Anschluss des ersten Varaktors (12) und der kathodische Anschluss des zweiten Varaktors (14) miteinander, mit dem Sourcekontakt oder Emitteranschluss eines ersten Transistors (22), mit dem Drainkontakt oder Kollektoranschluss eines zweiten Transistors (24), mit dem Drainkontakt oder Kollektoranschluss eines dritten Transistors (26) und mit dem Gatekontakt oder Basisanschluss eines vierten Transistors (28) verbunden sind, und
- einen dritten Varaktor (14) und einen vierten Varaktor (16), wobei der kathodische Anschluss des dritten Varaktors (14) und der kathodische Anschluss des vierten Varaktors (16) miteinander, mit dem Sourcekontakt oder Emitteranschluss eines fünften Transistors (32), mit dem Drainkontakt oder Kollektoranschluss eines sechsten Transistors (34), mit dem Gatekontakt oder Basisanschluss des dritten Transistors (26) und mit dem Drainkontakt oder Kollektoranschluss des vierten Transistors (28) verbunden sind.

Hierbei
- sind der Gatekontakt oder Basisanschluss des ersten Transistors (22) und der Gatekontakt oder Basisanschluss des fünften Transistors (32) miteinander verbunden sind und mit dem Regelspannungssignal (VBP) beaufschlagbar,
- sind der Sourcekontakt oder Emitteranschluss des zweiten Transistors (24) und der Sourcekontakt oder Emitteranschluss des sechsten Transistors (34) miteinander sowie mit dem Drainkontakt oder Kollektoranschluss eines siebten Transistors (66) verbunden, dessen Gatekontakt oder Basisanschluss mit einem ersten Ausgangsspannungssignal (VBNF) des Strom-Spannungs-Umsetzers (1/GM) beaufschlagbar ist und dessen Sourcekontakt oder Emitteranschluss auf einem Bezugspotential oder Referenzpotential (GND), insbesondere auf Erdpotential oder auf Massepotential oder auf Nullpotential, liegt,
- sind der Sourcekontakt oder Emitteranschluss des dritten Transistors (26) und der Sourcekontakt oder Emitteranschluss des vierten Transistors (28) miteinander sowie mit dem Drainkontakt oder Kollektoranschluss eines achten Transistors (38) verbunden, dessen Gatekontakt oder Basisanschluss mit einem zweiten Ausgangsspannungssignal (VBNS) des Strom-Spannungs-Umsetzers (1/GM) beaufschlagbar ist und dessen Sourcekontakt oder Emitteranschluss auf einem Bezugspotential oder Referenzpotential (GND), insbesondere auf Erdpotential oder auf Massepotential oder auf Nullpotential, liegt.

Die zweite Regelschleife in Form der Phasen-Regelungsschaltung weist einen Phasendetektor PD, eine dem Phasendetektor PD nachgeschaltete Ladungspumpe CP, einen der Ladungspumpe CP nachgeschalteten Spannungs-Strom-Umsetzer GM und den spannungsgesteuerten Oszillator VCO auf.

Wie der Detaildarstellung gemäß Fig. 7 entnehmbar, weist der der Phasendetektor PD eine als zustandsgesteuertes Flip-Flop ausgebildete Latch-Schaltung auf
- wobei der Sourcekontakt oder Emitteranschluss eines ersten Transistors (42) mit dem Drainkontakt oder Kollektoranschluss eines zweiten Transistors (44), mit dem Drainkontakt oder Kollektoranschluss eines dritten Transistors (46) und mit dem Gatekontakt oder Basisanschluss eines vierten Transistors (48) verbunden sind,
- wobei der Sourcekontakt oder Emitteranschluss eines fünften Transistors (52) mit dem Drainkontakt oder Kollektoranschluss eines sechsten Transistors (54), mit dem Gatekontakt oder Basisanschluss des dritten Transistors (46) und mit dem Drainkontakt oder Kollektoranschluss des vierten Transistors (48) verbunden sind und
- wobei der Gatekontakt oder Basisanschluss des ersten Transistors (42) und der Gatekontakt oder Basisanschluss des fünften Transistors (52) miteinander verbunden sind und mit dem Regelspannungssignal (VBP) beaufschlagbar sind.

Hierbei
- sind der Sourcekontakt oder Emitteranschluss des zweiten Transistors (44) und der Sourcekontakt oder Emitteranschluss des sechsten Transistors (54) miteinander sowie mit dem Drainkontakt oder Kollektoranschluss eines siebten Transistors (56) verbunden, dessen Gatekontakt oder Basisanschluss mit einem ersten Taktsignal (CKP) beaufschlagbar ist,
- sind der Sourcekontakt oder Emitteranschluss des dritten Transistors (46) und der Sourcekontakt oder Emitteranschluss des vierten Transistors (48) miteinander sowie mit dem Drainkontakt oder Kollektoranschluss eines achten Transistors (58) verbunden, dessen Gatekontakt oder Basisanschluss mit einem zweiten Taktsignal (CKN) beaufschlagbar ist,
- sind der Sourcekontakt oder Emitteranschluss des siebten Transistors (56) und der Sourcekontakt oder Emitteranschluss des achten Transistors (58) miteinander sowie mit dem Drainkontakt oder Kollektoranschluss eines neunten Transistors (60) verbunden, dessen Sourcekontakt oder Emitteranschluss auf einem Bezugspotential oder Referenzpotential (GND), insbesondere auf Erdpotential oder auf Massepotential oder auf Nullpotential, liegt.

Der Eingang des Strom-Spannungs-Umsetzers 1/GM wird mit dem mittels eines Addierers SUM summierten Ausgangsstrom des Strom-Digital-Analog-Wandlers I_DAC und des Spannungs-Strom-Umsetzers GM beaufschlagt.

Beim Einschalten der CDR-Schaltung 100 (vgl. Fig. 9), zum Beispiel nach Power ON-Reset, ist die erste Regelschleife, also die Frequenz-Regelung aktiv. Der Zustandsblock FSM vergleicht die Anzahl der Datenflanken mit der Anzahl der Taktflanken und stellt an seinem Ausgang ein digitales acht Bit-Wort für den Eingang des Strom-Digital-Analog-Wandlers I_DAC zur Verfügung.

Hierbei wird die Zustandsmaschine oder der Zustandsblock FSM auch als endlicher Automat oder Zustandsautomat (englisch: finite state machine) bezeichnet und stellt ein Modell eines Verhaltens, bestehend aus Zuständen, Zustandsübergängen und Aktionen, dar.

Der Strom-Digital-Analog-Wandler I_DAC wandelt die Differenz der Daten- und Taktflanken in einen differentiellen Strom Idac_p und Idac_n um.

Die mittels eines Stromaddierers SUM gebildete Summe der Ströme aus dem Strom-Digital-Analog-Wandler I_DAC und aus dem Spannungs-Strom-Umsetzer GM wird im nachfolgenden Strom-Spannungs-Wandler 1/GM in entsprechende Spannungswerte VBNF und VBNS für den spannungsgesteuerten Oszillator VCO umgesetzt, wobei der differentielle Ausgangsstrom Idac_p, Idac_n des Spannungs-Strom-Umsetzers GM zu diesem Zeitpunkt null ist, denn die zweite Regelschleife in Form der Phasen-Regelungsschaltung ist nicht aktiv.

Die erste Regelschleife ist eine reine Frequenzregelung, die den Strom-Digital-Analog-Wandler I_DAC und den spannungsgesteuerten Oszillator VCO so einstellt, dass am Ende der Regelzeitkonstante die Oszillatorfrequenz gleich der Datenrate am Eingang der CDR-Schaltung 100 ist. Mit Hilfe dieser Regelung kann sich der spannungsgesteuerte Oszillator VCO stets auf die richtige Datenrate einstellen, solange sich die Datenrate in einem Bereich kleiner als Faktor 5 bewegt.

In Unterschied zum Stand der Technik sind keine zusätzlichen Teiler im spannungsgesteuerten Oszillator VCO notwendig, denn der spannungsgesteuerte Oszillator VCO alleine weist bereits einen Tuningbereich von etwa Faktor 5 über Prozess- (slow- und fast-Parameter) und Temperaturschwankungen (minus zwanzig Grad Celsius bis plus 120 Grad Celsius) auf, wie dem Diagramm gemäß Fig. 8 exemplarisch entnehmbar ist, in der der Tuningbereich des spannungsgesteuerten Oszillators VCO veranschaulicht ist.

Die Spannungswerte VBNF und VBNS stellen den Leitwert der spannungsgesteuerten Oszillator-Puffer-Stufen VCO, VCB auf die richtigen Werte ein; zusätzlich ist auch der Lastwiderstand in diesen Puffern auf den richtigen Wert einzustellen. Dies kann über die Regelspannung VBP realisiert werden, die der Gate-Spannung der durch die n-Kanal-Metall-Oxid-Halbleiter-Feldeffekttransistoren 22, 32 bzw. 42, 52 bereitgestellten NMOS-Last entspricht.

Da für Datenraten von wesentlich mehr als einem Gigahertz normalerweise Technologien mit Kanallängen von höchstens 0,13 Mikrometer eingesetzt werden, ist die maximal mögliche Versorgungsspannung eingeschränkt; zum Beispiel beträgt die maximale Versorgungsspannung für eine 0,13 Mikrometer-Technologie üblicherweise etwa 1,5 Volt. Dies bedeutet aber, dass die Spannung an VBP größer als die Versorgungsspannung (= etwa 2,2 Volt) sein muss, um eine optimale Funktionsweise zu gewährleisten.

Aus diesem Grund wird die Regelspannung VBP über einen als Spannungs-Regelungsschaltung fungierenden dritten oder weiteren oder zusätzlichen Regelkreis so eingestellt, dass sich für jedes eingestellte VBNS und VBNF der richtige, insbesondere optimale, Wert für die Regelspannung VBP einstellt.

Dieser weitere oder zusätzliche Regelkreis weist eine Ladungspumpe CP', eine Kopie oder Replica VCB des Puffers VCO und einen Operationsverstärker AMP auf. Die Ladungspumpe CP', die eine Spannung von bis zum Zweifachen der Versorgungsspannung VDD erzeugen kann, ist für diese Art der Regelung geeignet, denn die erhöhte Ausgangsspannung geht nur auf die Gateanschlüsse der NMOS-Last-Transistoren 22, 32 bzw. 42, 52; es wird also kein Strom am Ausgang der Pumpe CP' benötigt.

Nachdem die erste Regelschleife oder Frequenz-Regelschleife die VCO-Frequenz und die Arbeitspunkte der C[urrent]M[ode]L[ogic]-Gatter im Phasendetektor PD und im spannungsgesteuerten Oszillator VCO auf die - in Abhängigkeit von der Datenrate - richtigen Werte eingestellt hat, wird der acht Bit-Wert für den Strom-Digital-Analog-Wandler I_DAC eingefroren und auf die zweite Regelschleife oder Phasen-Regelschleife umgeschaltet.

In dieser zweiten Regelschleife wird im Phasendetektor PD die Phasendifferenz zwischen Dateneingang und Takteingang der Schaltungsanordnung 100 ermittelt (voreilend oder nacheilend) und als digitale Signale up (für voreilend: UP) und down (für nacheilend: DN) am Eingang der Ladungspumpe CP zur Verfügung gestellt.

Die Ladungspumpe CP wandelt die ankommenden UP- bzw. DN-Signale in eine Tuningspannung tune_p bzw. tune_n, und der nachfolgende Spannungs-Strom-Umsetzer GM stellt einen differentiellen Strom Igm_p und Igm_n am Ausgang zur Verfügung.

Anschließend wird der Strom Igm_p bzw. Igm_n des Spannungs-Strom-Umsetzers GM im Stromaddierer SUM mit dem bereits voreingestellten Strom Idac_p bzw. Idac_n des Strom-Digital-Analog-Wandlers I_DAC summiert und im Strom-Spannungs-Wandler 1/GM als Ausgangsspannung VBNF und VBNS für den spannungsgesteuerten Oszillator VCO zur Verfügung gestellt.

Diese zweite Regelschleife ist eine reine Phasenregelung und weist einen Tuningbereich von etwa drei Prozent auf.

Im Ergebnis wird mittels der vorliegenden Erfindung ein CDR-Konzept (vgl. Fig. 9) für einen großen Tuningbereich (<--> Faktor von mindestens 5) bei niedriger Verlustleistung bereit gestellt. Hierzu werden die resistiven Lasten in der C[urrent]M[ode]L[ogic] durch als Lastwiderstände arbeitende NMOS-Transistoren 22, 32 (vgl. Fig. 6: VCO-Puffer-Stufe mit Transistor-Load, nämlich mit NMOS-Last 22, 32) ersetzt.

Durch diese Maßnahme kann sowohl der Leitwert der VCO-Puffer-Stufe als auch die Ausgangslast in Abhängigkeit von der Oszillator-Ausgangsfrequenz variiert werden, was zu einem höheren Tuningbereich des spannungsgesteuerten Oszillators VCO, VCB führt.

Da auch in der C[urrent]M[ode]L[ogic] des Phasendetektors PD in allen Logik-Gattern die resistiven Lasten durch NMOS-Lasten 42, 52 ersetzt werden (vgl. Fig. 7: Latch mit Transistor-Load, nämlich mit NMOS-Last 42, 52), wird die Verlustleistung der CDR-Schaltung 100 (vgl. Fig. 9) automatisch abhängig von der Datenrate am (Daten-)Eingang der CDR-Schaltung 100. Dies bedeutet zum Beispiel, dass bei Halbierung der Datenrate am CDR-Eingang die Verlustleistung der der CDR-Schaltung 100um den Faktor 4 reduziert wird.

### Bezugszeichenliste

- 100: Schaltungsanordnung zur Takt- und/oder Datenrückgewinnung
- 12: erster Varaktor des spannungsgesteuerten Oszillators VCO und/oder der spannungsgesteuerten Oszillator-Puffer-Stufe VCB
- 14: zweiter Varaktor des spannungsgesteuerten Oszillators VCO und/oder der spannungsgesteuerten Oszillator-Puffer-Stufe VCB
- 16: dritter Varaktor des spannungsgesteuerten Oszillators VCO und/oder der spannungsgesteuerten Oszillator-Puffer-Stufe VCB
- 18: vierter Varaktor des spannungsgesteuerten Oszillators VCO und/oder der spannungsgesteuerten Oszillator-Puffer-Stufe VCB
- 22: erster Transistor, insbesondere n-Kanal-Metall-Oxid-Halbleiter-Feldeffekttransistor, des spannungsgesteuerten Oszillators VCO und/oder der spannungsgesteuerten Oszillator-Puffer-Stufe VCB
- 24: zweiter Transistor des spannungsgesteuerten Oszillators VCO und/oder der spannungsgesteuerten Oszillator-Puffer-Stufe VCB
- 26: dritter Transistor des spannungsgesteuerten Oszillators VCO und/oder der spannungsgesteuerten Oszillator-Puffer-Stufe VCB
- 28: vierter Transistor des spannungsgesteuerten Oszillators VCO und/oder der spannungsgesteuerten Oszillator-Puffer-Stufe VCB
- 32: fünfter Transistor, insbesondere n-Kanal-Metall-Oxid-Halbleiter-Feldeffekttransistor, des spannungsgesteuerten Oszillators VCO und/oder der spannungsgesteuerten Oszillator-Puffer-Stufe VCB
- 34: sechster Transistor des spannungsgesteuerten Oszillators VCO und/oder der spannungsgesteuerten Oszillator-Puffer-Stufe VCB
- 36: siebter Transistor des spannungsgesteuerten Oszillators VCO und/oder der spannungsgesteuerten Oszillator-Puffer-Stufe VCB
- 38: achter Transistor des spannungsgesteuerten Oszillators VCO und/oder der spannungsgesteuerten Oszillator-Puffer-Stufe VCB
- 42: erster Transistor, insbesondere n-Kanal-Metall-Oxid-Halbleiter-Feldeffekttransistor, der Latch-Schaltung, insbesondere der Flip-Flop-Schaltung, zum Beispiel der zustandsgesteuerten Flip-Flop-Schaltung, des Phasendetektors PD
- 44: zweiter Transistor der Latch-Schaltung, insbesondere der Flip-Flop-Schaltung, zum Beispiel der zustandsgesteuerten Flip-Flop-Schaltung, des Phasendetektors PD
- 46: dritter Transistor der Latch-Schaltung, insbesondere der Flip-Flop-Schaltung, zum Beispiel der zustandsgesteuerten Flip-Flop-Schaltung, des Phasendetektors PD
- 48: vierter Transistor der Latch-Schaltung, insbesondere der Flip-Flop-Schaltung, zum Beispiel der zustandsgesteuerten Flip-Flop-Schaltung, des Phasendetektors PD
- 52: fünfter Transistor, insbesondere n-Kanal-Metall-Oxid-Halbleiter-Feldeffekttransistor, der Latch-Schaltung, insbesondere der Flip-Flop-Schaltung, zum Beispiel der zustandsgesteuerten Flip-Flop-Schaltung, des Phasendetektors PD
- 54: sechster Transistor der Latch-Schaltung, insbesondere der Flip-Flop-Schaltung, zum Beispiel der zustandsgesteuerten Flip-Flop-Schaltung, des Phasendetektors PD
- 56: siebter Transistor der Latch-Schaltung, insbesondere der Flip-Flop-Schaltung, zum Beispiel der zustandsgesteuerten Flip-Flop-Schaltung, des Phasendetektors PD
- 58: achter Transistor der Latch-Schaltung, insbesondere der Flip-Flop-Schaltung, zum Beispiel der zustandsgesteuerten Flip-Flop-Schaltung, des Phasendetektors PD
- 60: neunter Transistor der Latch-Schaltung, insbesondere der Flip-Flop-Schaltung, zum Beispiel der zustandsgesteuerten Flip-Flop-Schaltung, des Phasendetektors PD
- AMP: Operationsverstärker
- CKP: erstes Taktsignal
- CKN: zweites Taktsignal
- CP: Ladungspumpe der Phasen-Regelungsschaltung, insbesondere der zweiten Regelschleife
- CP': Ladungspumpe der Spannungs-Regelungsschaltung, insbesondere der dritten oder weiteren oder zusätzlichen Regelschleife
- FSM: Zustandsmaschine, insbesondere endlicher Automat oder Zustandsautomat
- GM: Spannungs-Strom-Umsetzer
- 1/GM: Strom-Spannungs-Umsetzer, insbesondere Transimpedanzverstärker
- GND: Bezugspotential oder Referenzpotential, insbesondere Erdpotential oder Massepotential oder Nullpotential
- Idac_p,n: differentieller Strom am Ausgang des Strom-Digital-Analog-Wandlers I_DAC
- I_DAC: Strom-Digital-Analog-Wandler
- Igm_p,n: differentieller Strom am Ausgang des Spannungs-Strom-Umsetzers GM
- PD: Phasendetektor, insbesondere binärer Phasendetektor, zum Beispiel Bang-Bang-Phasendetektor oder Aufwärts/Abwärts-Phasendetektor
- SUM: Addierer, insesondere Stromaddierer
- tune_p,n: Tuning-Spannung
- VBNF: erstes Ausgangsspannungssignal des Strom-Spannungs-Umsetzers 1/GM
- VBNS: zweites Ausgangsspannungssignal des Strom-Spannungs-Umsetzers 1/GM
- VBP: Regelspannung(ssignal)
- VCO: spannungsgesteuerter Oszillator, insbesondere spannungsgesteuerter LC-Oszillator, zum Beispiel Ringoszillator, oder spannungsgesteuerte Oszillator-Puffer-Stufe der Phasen-Regelungsschaltung, insbesondere der zweiten Regelschleife
- VCB: spannungsgesteuerter Oszillator, insbesondere spannungsgesteuerter LC-Oszillator, zum Beispiel Ringoszillator, oder spannungsgesteuerte Oszillator-Puffer-Stufe der Spannungs-Regelungsschaltung, insbesondere der dritten oder weiteren oder zusätzlichen Regelschleife
- VDD: Versorgungsspannung

## Patentansprüche

1. Schaltungsanordnung (100) zur Takt- und/oder Datenrückgewinnung, aufweisend
- mindestens einen Dateneingang,
- mindestens einen Takteingang,
- mindestens eine mit dem mindestens einen Dateneingang und mit dem mindestens einen Takteingang verbundene Frequenz-Regelungsschaltung mit
-- mindestens einer Zustandsmaschine (FSM),
-- mindestens einem der Zustandsmaschine (FSM) nachgeschalteten Strom-Digital-Analog-Wandler (I_DAC),
-- mindestens einem dem Strom-Digital-Analog-Wandler (I_DAC) nachgeschalteten Strom-Spannungs-Umsetzer (1/GM),
-- mindestens einem dem Strom-Spannungs-Umsetzer (1/GM) nachgeschalteten, mit mindestens einem Regelspannungssignal (VBP) beaufschlagbaren spannungsgesteuerten Ring-Oszillator (VCO) zum Erzeugen und Bereitstellen eines Taktsignals an dem mindestens einen Takteingang, wobei der spannungsgesteuerte Ring-Oszillator (VCO) mehrere spannungsgesteuerte Oszillator-Puffer-Stufen aufweist, die jeweils aufweisen:
--- einen ersten Varaktor (12) und einen zweiten Varaktor (14), wobei der kathodische Anschluss des ersten Varaktors (12) und der kathodische Anschluss des zweiten Varaktors (14) miteinander, mit dem Sourcekontakt oder Emitteranschluss eines ersten Transistors (22), mit dem Drainkontakt oder Kollektoranschluss eines zweiten Transistors (24), dessen Gatekontakt oder Basisanschluss mit einem Eingang der spannungsgesteuerten Oszillator-Puffer-Stufe verbunden ist, mit dem Drainkontakt oder Kollektoranschluss eines dritten Transistors (26), mit dem Gatekontakt oder Basisanschluss eines vierten Transistors (28) und mit einem Ausgang der spannungsgesteuerten Oszillator-Puffer-Stufe verbunden sind, und
--- einen dritten Varaktor (16) und einen vierten Varaktor (18), wobei der kathodische Anschluss des dritten Varaktors (16) und der kathodische Anschluss des vierten Varaktors (18) miteinander, mit dem Sourcekontakt oder Emitteranschluss eines fünften Transistors (32), mit dem Drainkontakt oder Kollektoranschluss eines sechsten Transistors (34), dessen Gatekontakt oder Basisanschluss mit einem weiteren Eingang der spannungsgesteuerten Oszillator-Puffer-Stufe verbunden ist, mit dem Gatekontakt oder Basisanschluss des dritten Transistors (26), mit dem Drainkontakt oder Kollektoranschluss des vierten Transistors (28) und mit einem weiteren Ausgang der spannungsgesteuerten Oszillator-Puffer-Stufe verbunden sind,
---- wobei der Gatekontakt oder Basisanschluss des ersten Transistors (22) und der Gatekontakt oder Basisanschluss des fünften Transistors (32) miteinander verbunden sind und mit dem Regelspannungssignal (VBP) beaufschlagbar sind,
---- wobei der Drainkontakt oder Kollektoranschluss des ersten Transistors (22) und der Drainkontakt oder Kollektoranschluss des fünften Transistors (32) miteinander und mit einer Versorgungsspannung verbunden sind,
---- wobei der Sourcekontakt oder Emitteranschluss des zweiten Transistors (24) und der Sourcekontakt oder Emitteranschluss des sechsten Transistors (34) miteinander sowie mit dem Drainkontakt oder Kollektoranschluss eines siebten Transistors (36) verbunden sind, dessen Gatekontakt oder Basisanschluss mit einem ersten Ausgangsspannungssignal (VBNF) des Strom-Spannungs-Umsetzers (1/GM) beaufschlagbar ist und dessen Sourcekontakt oder Emitteranschluss auf einem Bezugspotential oder Referenzpotential (GND), insbesondere auf Erdpotential oder auf Massepotential oder auf Nullpotential, liegt, und
---- wobei der Sourcekontakt oder Emitteranschluss des dritten Transistors (26) und der Sourcekontakt oder Emitteranschluss des vierten Transistors (28) miteinander sowie mit dem Drainkontakt oder Kollektoranschluss eines achten Transistors (38) verbunden sind, dessen Gatekontakt oder Basisanschluss mit einem zweiten Ausgangsspannungssignal (VBNS) des Strom-Spannungs-Umsetzers (1/GM) beaufschlagbar ist und dessen Sourcekontakt oder Emitteranschluss auf einem Bezugspotential oder Referenzpotential (GND), insbesondere auf Erdpotential oder auf Massepotential oder auf Nullpotential, liegt, und
- mindestens eine mit dem mindestens einen Dateneingang und mit dem mindestens einen Takteingang verbundene Phasen-Regelungsschaltung mit
-- mindestens einem Phasendetektor (PD), der mindestens eine, insbesondere als mindestens ein Flip-Flop, zum Beispiel als mindestens ein zustandsgesteuertes Flip-Flop, ausgebildete Latch-Schaltung aufweist,
--- wobei der Sourcekontakt oder Emitteranschluss eines ersten Transistors (42) mit dem Drainkontakt oder Kollektoranschluss eines zweiten Transistors (44), dessen Gatekontakt oder Basisanschluss mit einem Dateneingang der mindestens einen Latch-Schaltung verbunden ist, mit dem Drainkontakt oder Kollektoranschluss eines dritten Transistors (46), mit dem Gatekontakt oder Basisanschluss eines vierten Transistors (48) und mit einem Ausgang der mindestens einen Latch-Schaltung verbunden sind,
--- wobei der Sourcekontakt oder Emitteranschluss eines fünften Transistors (52) mit dem Drainkontakt oder Kollektoranschluss eines sechsten Transistors (54), dessen Gatekontakt oder Basisanschluss mit einem weiteren Dateneingang der mindestens einen Latch-Schaltung verbunden ist, mit dem Gatekontakt oder Basisanschluss des dritten Transistors (46), mit dem Drainkontakt oder Kollektoranschluss des vierten Transistors (48) und mit einem weiteren Ausgang der mindestens einen Latch-Schaltung verbunden sind und
--- wobei der Gatekontakt oder Basisanschluss des ersten Transistors (42) und der Gatekontakt oder Basisanschluss des fünften Transistors (52) miteinander verbunden sind und mit dem Regelspannungssignal (VBP) beaufschlagbar sind,
--- wobei der Drainkontakt oder Kollektoranschluss des ersten Transistors (42) und der Drainkontakt oder Kollektoranschluss des fünften Transistors (52) miteinander und mit der Versorgungsspannung verbunden sind,
---- wobei der Sourcekontakt oder Emitteranschluss des zweiten Transistors (44) und der Sourcekontakt oder Emitteranschluss des sechsten Transistors (54) miteinander sowie mit dem Drainkontakt oder Kollektoranschluss eines siebten Transistors (56) verbunden sind, dessen Gatekontakt oder Basisanschluss mit einem ersten Taktsignal (CKP) beaufschlagbar ist,
---- wobei der Sourcekontakt oder Emitteranschluss des dritten Transistors (46) und der Sourcekontakt oder Emitteranschluss des vierten Transistors (48) miteinander sowie mit dem Drainkontakt oder Kollektoranschluss eines achten Transistors (58) verbunden sind, dessen Gatekontakt oder Basisanschluss mit einem zweiten Taktsignal (CKN) beaufschlagbar ist, und
---- wobei der Sourcekontakt oder Emitteranschluss des siebten Transistors (56) und der Sourcekontakt oder Emitteranschluss des achten Transistors (58) miteinander sowie mit dem Drainkontakt oder Kollektoranschluss eines neunten Transistors (60) verbunden sind, dessen Sourcekontakt oder Emitteranschluss auf einem Bezugspotential oder Referenzpotential (GND), insbesondere auf Erdpotential oder auf Massepotential oder auf Nullpotential, liegt,
-- mindestens einer dem Phasendetektor (PD) nachgeschalteten Ladungspumpe (CP),
-- mindestens einem der Ladungspumpe (CP) nachgeschalteten Spannungs-Strom-Umsetzer (GM) sowie
-- dem spannungsgesteuerten Ring-Oszillator (VCO),
wobei zunächst nur die Frequenz-Regelungsschaltung zum Einstellen der Frequenz in Abhängigkeit von der Datenrate, mit der der Dateneingang beaufschlagbar ist, aktiv ist und dann durch Umschalten auf die Phasen-Regelungsschaltung die Phasendifferenz zwischen dem Dateneingang und dem Takteingang ermittelbar ist.

2. Schaltungsanordnung gemäß Anspruch 1, **dadurch gekennzeichnet, dass** der Strom-Digital-Analog-Wandler (I_DAC) acht Bit-programmierbar, insbesondere mit einem digitalen acht Bit-Wort beaufschlagbar, ist.

3. Schaltungsanordnung gemäß Anspruch 1 oder 2, **dadurch gekennzeichnet, dass** der Strom-Spannungs-Umsetzer (1/GM) als mindestens ein Transimpedanzverstärker ausgebildet ist.

4. Schaltungsanordnung gemäß mindestens einem der Ansprüche 1 bis 3, **gekennzeichnet durch** mindestens eine zum Einstellen des Regelspannungssignals (VBP) vorgesehene Spannungs-Regelungsschaltung
- mit mindestens einer spannungsgesteuerten Nachbildungsoszillator-Puffer-Stufe (VCB), die mit den spannungsgesteuerten Oszillator-Puffer-Stufen identisch ist,
- mit mindestens einem der spannungsgesteuerten Nachbildungsoszillator-Puffer-Stufe (VCB) nachgeschalteten Operationsverstärker (AMP) und
- mit mindestens einer dem Operationsverstärker (AMP) nachgeschalteten Ladungspumpe (CP').

5. Schaltungsanordnung gemäß mindestens einem der Ansprüche 1 bis 4, **dadurch gekennzeichnet, dass** der Phasendetektor (PD) als mindestens ein binärer Phasendetektor, insbesondere als mindestens ein Bang-Bang-Phasendetektor oder als mindestens ein Aufwärts/Abwärts-Phasendetektor, ausgebildet ist.

6. Schaltungsanordnung gemäß mindestens einem der Ansprüche 1 bis 5, **dadurch gekennzeichnet, dass**
- der erste Transistor (22) und/oder der fünfte Transistor (32) des spannungsgesteuerten Oszillators (VCO) und/oder
- der erste Transistor (42) und/oder der fünfte Transistor (42) der Latch-Schaltung des Phasendetektors (PD)
als n-Kanal-Metall-Oxid-Halbleiter-Feldeffekttransistor ausgebildet sind/ist.

7. Schaltungsanordnung gemäß mindestens einem der Ansprüche 1 bis 6, **dadurch gekennzeichnet, dass** der Eingang des Strom-Spannungs-Umsetzers (1/GM) mit dem mittels mindestens eines Addierers (SUM) summierten Ausgangsstrom des Strom-Digital-Analog-Wandlers (I_DAC) und des Spannungs-Strom-Umsetzers (GM) beaufschlagbar ist.

8. Verfahren zur Takt- und/oder Datenrückgewinnung mittels mindestens einer Schaltungsanordnung (100) gemäß mindestens einem der Ansprüche 1 bis 7, aufweisend
- mindestens eine Frequenz-Regelung durch die mindestens eine Frequenz-Regelungsschaltung, J und
- mindestens eine Phasen-Regelung durch die mindestens eine Phasen-Regelungsschaltung, wobei zunächst nur die Frequenz-Regelung zum Einstellen der Frequenz in Abhängigkeit von der Datenrate aktiv ist und dann zum Ermitteln der Phasendifferenz zwischen Dateneingang und Takteingang auf die Phasen-Regelung umgeschaltet wird.

9. Verwendung mindestens einer Schaltungsanordnung (100) gemäß mindestens einem der Ansprüche 1 bis 7 und/oder eines Verfahrens gemäß Anspruch 8 zur Takt- und/oder Datenrückgewinnung.

## Claims

1. Circuit arrangement (100) for clock and/or data recovery, comprising
- at least one data input,
- at least one clock input,
- at least one frequency regulation circuit connected to the at least one data input and to the at least one clock input, comprising
-- at least one finite state machine (FSM),
-- at least one current-digital-analogue converter (I_DAC) connected downstream of the finite state machine (FSM),
-- at least one current-voltage converter (1/GM) connected downstream of the current-digital-analogue converter (I_DAC),
-- at least one voltage-controlled ring oscillator (VCO) connected downstream of the current-voltage converter (1/GM), said voltage-controlled ring oscillator (VCO) suppliable with at least one regulation voltage signal (VBP), said voltage-controlled ring oscillator (VCO) for generating and providing a clock signal at the at least one clock input, wherein the voltage-controlled ring oscillator (VCO) comprises several voltage-controlled oscillator buffer stages, each of which comprises:
--- a first varactor (12) and a second varactor (14), wherein the cathode terminal of the first varactor (12) and the cathode terminal of the second varactor (14) are connected to each other, to the source contact or emitter terminal of a first transistor (22), to the drain contact or collector terminal of a second transistor (24), whose gate contact or base terminal is connected to an input of the voltage-controlled oscillator buffer stage, to the drain contact or collector terminal of a third transistor (26), to the gate contact or base terminal of a fourth transistor (28) and to an output of the voltage-controlled oscillator buffer stage, and
--- a third varactor (16) and a fourth varactor (18), wherein the cathode terminal of the third varactor (16) and the cathode terminal of the fourth varactor (18) are connected to each other, to the source contact or emitter terminal of a fifth transistor (32), to the drain contact or collector terminal of a sixth transistor (34), whose gate contact or base terminal is connected to a further input of the voltage-controlled oscillator buffer stage, to the gate contact or base terminal of the third transistor (26), to the drain contact or collector terminal of the fourth transistor (28) and to a further output of the voltage-controlled oscillator buffer stage,
---- wherein the gate contact or base terminal of the first transistor (22) and the gate contact or base terminal of the fifth transistor (32) are connected to each other and are suppliable with the regulation voltage signal (VBP),
---- wherein the drain contact or collector terminal of the first transistor (22) and the drain contact or collector terminal of the fifth transistor (32) are connected to each other and to a supply voltage,
---- wherein the source contact or emitter terminal of the second transistor (24) and the source contact or emitter terminal of the sixth transistor (34) are connected to each other and to the drain contact or collector terminal of a seventh transistor (36), whose gate contact or base terminal is suppliable with a first output voltage signal (VBNF) of the current-voltage converter (1/GM) and whose source contact or emitter terminal is at a reference potential (GND), in particular at earth potential or at ground potential or at zero potential, and
---- wherein the source contact or emitter terminal of the third transistor (26) and the source contact or emitter terminal of the fourth transistor (28) are connected to each other and to the drain contact or collector terminal of an eighth transistor (38), whose gate contact or base terminal is suppliable with a second output voltage signal (VBNS) of the current-voltage converter (1/GM) and whose source contact or emitter terminal is at a reference potential (GND), in particular at earth potential or at ground potential or at zero potential, and
- at least one phase regulation circuit connected to the at least one data input and to the at least one clock input, comprising
-- at least one phase detector (PD) comprising at least one latch circuit, in particular embodied as at least one flip-flop, for example as at least one state-controlled flip-flop,
--- wherein the source contact or emitter terminal of a first transistor (42) is connected to the drain contact or collector terminal of a second transistor (44), whose gate contact or base terminal is connected to a data input of the at least one latch circuit, to the drain contact or collector terminal of a third transistor (46), to the gate contact or base terminal of a fourth transistor (48) and to an output of the at least one latch circuit,
--- wherein the source contact or emitter terminal of a fifth transistor (52) is connected to the drain contact or collector terminal of a sixth transistor (54), whose gate contact or base terminal is connected to a further data input of the at least one latch circuit, to the gate contact or base terminal of the third transistor (46), to the drain contact or collector terminal of the fourth transistor (48) and to a further output of the at least one latch circuit, and
--- wherein the gate contact or base terminal of the first transistor (42) and the gate contact or base terminal of the fifth transistor (52) are connected to each other and are suppliable with the regulation voltage signal (VBP),
--- wherein the drain contact or collector terminal of the first transistor (42) and the drain contact or collector terminal of the fifth transistor (52) are connected to each other and to the supply voltage,
---- wherein the source contact or emitter terminal of the second transistor (44) and the source contact or emitter terminal of the sixth transistor (54) are connected to each other and to the drain contact or collector terminal of a seventh transistor (56), whose gate contact or base terminal is suppliable with a first clock signal (CKP),
---- wherein the source contact or emitter terminal of the third transistor (46) and the source contact or emitter terminal of the fourth transistor (48) are connected to each other and to the drain contact or collector terminal of an eighth transistor (58), whose gate contact or base terminal is suppliable with a second clock signal (CKN), and
---- wherein the source contact or emitter terminal of the seventh transistor (56) and the source contact or emitter terminal of the eighth transistor (58) are connected to each other and to the drain contact or collector terminal of a ninth transistor (60), whose source contact or emitter terminal is at a reference potential (GND), in particular at earth potential or at ground potential or at zero potential,
-- at least one charge pump (CP) connected downstream of the phase detector (PD),
-- at least one voltage-current converter (GM) connected downstream of the charge pump (CP), and
-- the voltage-controlled ring oscillator (VCO),
wherein initially only the frequency regulation circuit is active for setting the frequency depending on the data rate with which the data input is suppliable, and then by switching to the phase regulation circuit, the phase difference between the data input and the clock input is determinable.

2. Circuit arrangement according to claim 1, **characterized in that** the current-digital-analogue converter (I_DAC) is eight-bit programmable, in particular is suppliable with a digital eight-bit word.

3. Circuit arrangement according to claim 1 or 2, **characterized in that** the current-voltage converter (1/GM) is embodied as at least one transimpedance amplifier.

4. Circuit arrangement according to at least one of claims 1 to 3, **characterized by** at least one voltage regulation circuit provided for setting the regulation voltage signal (VBP)
- with at least one voltage-controlled replica oscillator buffer stage (VCB) which is identical to the voltage-controlled oscillator buffer stages,
- with at least one operational amplifier (AMP) connected downstream of the voltage-controlled replica oscillator buffer stage (VCB), and
- with at least one charge pump (CP') connected downstream of the operational amplifier (AMP).

5. Circuit arrangement according to at least one of claims 1 to 4, **characterized in that** the phase detector (PD) is embodied as at least one binary phase detector, in particular of at least one bang-bang phase detector or of at least one up/down phase detector.

6. Circuit arrangement according to at least one of claims 1 to 5, **characterized in that**
- the first transistor (22) and/or the fifth transistor (32) of the voltage-controlled oscillator (VCO) and/or
- the first transistor (42) and/or the fifth transistor (52) of the latch circuit of the phase detector (PD) are/is embodied as n-channel metal oxide semiconductor field effect transistor(s).

7. Circuit arrangement according to at least one of claims 1 to 6, **characterized in that** the input of the current-voltage converter (1/GM) is suppliable with the output current of the current-digital-analogue converter (I_DAC) and of the voltage-current converter (GM), said output current summed by means of at least one adder (SUM).

8. Method for clock and/or data recovery by means of at least one circuit arrangement (100) according to at least one of claims 1 to 7, comprising
- at least one frequency regulation by the at least one frequency regulation circuit and
- at least one phase regulation by the at least one phase regulation circuit,
wherein initially only the frequency regulation is active for setting the frequency depending on the data rate, and then, for determining the phase difference between data input and clock input, it is switched to the phase regulation.

9. Use of at least one circuit arrangement (100) according to at least one of claims 1 to 7 and/or of a method according to claim 8 for clock and/or data recovery.

## Revendications

1. Circuiterie (100) pour la récupération d'horloge et/ou de données, comportant
- au moins une entrée de données,
- au moins une entrée d'horloge,
- au moins un circuit de régulation de fréquence relié au au moins une entrée de données et au au moins une entrée d'horloge, comportant
-- au moins une machine à états finis (FSM),
-- au moins un convertisseur courant-numérique-analogique (I_DAC) connecté en aval de la machine à états finis (FSM),
-- au moins un convertisseur courant-tension (1/GM) connecté en aval du convertisseur courant-numérique-analogique (I_DAC),
-- au moins un oscillateur en anneau commandé en tension (VCO) connecté en aval du convertisseur courant-tension (1/GM), ledit oscillateur en anneau commandé en tension (VCO) pouvant être alimenté par au moins un signal de tension de régulation (VBP), ledit oscillateur en anneau commandé en tension (VCO) pour générer et fournir un signal d'horloge à la au moins une entrée d'horloge, l'oscillateur en anneau commandé en tension (VCO) comportant plusieurs étages tampons oscillateurs commandés en tension qui comportent chacun :
--- un premier varactor (12) et un deuxième varactor (14), la borne cathodique du premier varactor (12) et la borne cathodique du deuxième varactor (14) étant reliées entre elles, au contact source ou à la borne émetteur d'un premier transistor (22), au contact drain ou à la borne collecteur d'un deuxième transistor (24), dont le contact de grille ou la borne de base est relié à une entrée de l'étage tampon oscillateur commandé en tension, au contact de drain ou à la borne de collecteur d'un troisième transistor (26), au contact de grille ou à la borne de base d'un quatrième transistor (28) et à une sortie de l'étage tampon oscillateur commandé en tension, et
--- un troisième varactor (16) et un quatrième varactor (18), la borne cathodique du troisième varactor (16) et la borne cathodique du quatrième varactor (18) étant reliées entre elles, au contact source ou à la borne émetteur d'un cinquième transistor (32), au contact de drain ou à la borne de collecteur d'un sixième transistor (34), dont le contact de grille ou la borne de base est relié à une autre entrée de l'étage tampon oscillateur commandé en tension, au contact de grille ou à la borne de base du troisième transistor (26), au contact de drain ou à la borne de collecteur du quatrième transistor (28) et à une sortie de l'étage tampon oscillateur commandé en tension,
---- le contact de grille ou la borne de base du premier transistor (22) et le contact de grille ou la borne de base du cinquième transistor (32) étant reliés entre eux et pouvant être alimentés par le signal de tension de régulation (VBP),
---- le contact de drain ou la borne de collecteur du premier transistor (22) et le contact de drain ou la borne de collecteur du cinquième transistor (32) étant reliés entre eux et à une tension d'alimentation,
---- le contact source ou la borne émetteur du deuxième transistor (24) et le contact source ou la borne émetteur du sixième transistor (34) étant reliés entre eux et au contact drain ou à la borne collecteur d'un septième transistor (36), dont le contact grille ou la borne base peut être alimenté par un premier signal de tension de sortie (VBNF) du convertisseur courant-tension (1/GM) et dont le contact source ou la borne émetteur est à un potentiel de référence (GND), en particulier au potentiel de terre ou au potentiel de masse ou au potentiel zéro, et
---- le contact source ou la borne émetteur du troisième transistor (26) et le contact source ou la borne émetteur du quatrième transistor (28) étant reliés entre eux et au contact drain ou à la borne collecteur d'un huitième transistor (38), dont le contact grille ou la borne base peut être alimenté par un deuxième signal de tension de sortie (VBNS) du convertisseur courant-tension (1/GM) et dont le contact source ou la borne émetteur est à un potentiel de référence (GND), en particulier au potentiel de terre ou au potentiel de masse ou au potentiel zéro, et
- au moins un circuit de régulation de phase relié à la au moins une entrée de données et à la au moins une entrée d'horloge, comportant
-- au moins un détecteur de phase (PD) qui comporte au moins un circuit de verrouillage, en particulier conçu comme au moins une bascule, par exemple comme au moins une bascule commandée par l'état,
--- le contact source ou la borne émetteur d'un premier transistor (42) étant relié au contact drain ou à la borne collecteur d'un deuxième transistor (44), dont le contact grille ou la borne base est relié à une entrée de données du au moins un circuit de verrouillage, au contact drain ou à la borne collecteur d'un troisième transistor (46), au contact de grille ou à la borne de base d'un quatrième transistor (48) et à une sortie du au moins un circuit de verrouillage,
--- le contact source ou la borne émetteur d'un cinquième transistor (52) étant relié au contact drain ou à la borne collecteur d'un sixième transistor (54), dont le contact grille ou la borne base est relié à une autre entrée de données du au moins un circuit de verrouillage, au contact grille ou à la borne base du troisième transistor (46), au contact de drain ou à la borne de collecteur du quatrième transistor (48) et à une autre sortie du au moins un circuit de verrouillage, et
--- le contact de grille ou la borne de base du premier transistor (42) et le contact de grille ou la borne de base du cinquième transistor (52) étant reliés entre eux et peuvent être alimentés par le signal de tension de régulation (VBP),
--- le contact de drain ou la borne de collecteur du premier transistor (42) et le contact de drain ou la borne de collecteur du cinquième transistor (52) étant reliés entre eux et à la tension d'alimentation,
---- le contact source ou la borne émetteur du deuxième transistor (44) et le contact source ou la borne émetteur du sixième transistor (54) étant reliés entre eux et au contact drain ou à la borne collecteur d'un septième transistor (56), dont le contact grille ou la borne base peut être alimenté par un premier signal d'horloge (CKP),
---- le contact source ou la borne émetteur du troisième transistor (46) et le contact source ou la borne émetteur du quatrième transistor (48) étant reliés entre eux et au contact drain ou à la borne collecteur d'un huitième transistor (58), dont le contact grille ou la borne base peut être alimenté par un deuxième signal d'horloge (CKN), et
---- le contact source ou la borne émetteur du septième transistor (56) et le contact source ou la borne émetteur du huitième transistor (58) étant reliés entre eux et au contact drain ou à la borne collecteur d'un neuvième transistor (60), dont le contact source ou la borne émetteur est à un potentiel de référence (GND), en particulier au potentiel de terre ou au potentiel de masse ou au potentiel zéro,
-- au moins une pompe de charge (CP) connectée en aval du détecteur de phase (PD),
-- au moins un convertisseur tension-courant (GM) connecté en aval de la pompe de charge (CP) et
-- l'oscillateur en anneau commandé en tension (VCO),
initialement seul le circuit de régulation de fréquence étant actif pour régler la fréquence en fonction du débit de données par lequel l'entrée de données peut être alimentée, et puis la différence de phase entre l'entrée de données et l'entrée d'horloge est déterminable par commuter sur le circuit de régulation de phase.

2. Circuiterie selon la revendication 1, **caractérisée en ce que** le convertisseur courant-numérique-analogique (I_DAC) est programmable sur huit bits, en particulier peut être alimenté par un mot numérique de huit bits.

3. Circuiterie selon la revendication 1 ou 2, **caractérisée en ce que** le convertisseur courant-tension (1/GM) est conçu comme au moins un amplificateur à transimpédance.

4. Circuiterie selon au moins l'une des revendications 1 à 3, **caractérisée par** au moins un circuit de régulation de tension prévu pour régler le signal de tension de régulation (VBP)
- avec au moins un étage tampon oscillateur à réplique commandé en tension (VCB) identique aux étages tampons oscillateurs commandés en tension,
- avec au moins un amplificateur opérationnel (AMP) connecté en aval de l'étage tampon oscillateur à réplique commandé en tension (VCB) et
- avec au moins une pompe de charge (CP') connectée en aval de l'amplificateur opérationnel (AMP).

5. Circuiterie selon au moins l'une des revendications 1 à 4, **caractérisée en ce que** le détecteur de phase (PD) est conçu comme au moins un détecteur de phase binaire, en particulier comme au moins un détecteur de phase bang-bang ou comme au moins un détecteur de phase ascendant/descendant.

6. Circuiterie selon au moins l'une des revendications 1 à 5, **caractérisée en ce que**
- le premier transistor (22) et/ou le cinquième transistor (32) de l'oscillateur commandé en tension (VCO) et/ou
- le premier transistor (42) et/ou le cinquième transistor (52) du circuit de verrouillage du détecteur de phase (PD)
est/sont conçus comme des transistors à effet de champ à semi-conducteur à oxyde métallique à canal n.

7. Circuiterie selon au moins l'une des revendications 1 à 6, **caractérisée en ce que** l'entrée du convertisseur courant-tension (1/GM) peut être alimentée par le courant de sortie du convertisseur courant-numérique-analogique (I_DAC) et du convertisseur tension-courant (GM), ledit courant de sortie additionné au moyen d'au moins un additionneur (SUM).

8. Procédé pour la récupération d'horloge et/ou de données au moyen d'au moins une circuiterie (100) selon au moins l'une des revendications 1 à 7, comportant
- au moins une régulation de fréquence par le au moins un circuit de régulation de fréquence et
- au moins une régulation de phase par le au moins un circuit de régulation de phase,
initialement seule la régulation de fréquence étant active pour régler la fréquence en fonction du débit de données, et puis on commute sur la régulation de phase pour déterminer la différence de phase entre entrée de données et entrée d'horloge.

9. Utilisation d'au moins un circuiterie (100) selon au moins l'une des revendications 1 à 7 et/ou d'un procédé selon la revendication 8 pour la récupération d'horloge et/ou de données.
